# EUROPÄISCHE PATENTSCHRIFT

(11) **EP 2 728 749 B1**
(45) Veröffentlichungstag und Bekanntmachung des Hinweises auf die Patenterteilung: **26.01.2022**
(21) Anmeldenummer: 13191537.3
(22) Anmeldetag: 05.11.2013
(51) Int. Cl.: H03G 11/00, H03G 11/02, H02H 9/04

(54) **Begrenzer für breitbandige Hochfrequenzsignale**
Limiter for broadband high frequency signals
Limiteur pour des signaux haute fréquence à large bande

(30) Priorität: 06.11.2012 DE 102012220133; 02.04.2013 DE 102013205805
(43) Veröffentlichungstag der Anmeldung: 07.05.2014
(73) Patentinhaber: Rohde & Schwarz GmbH & Co. KG, 81671 München (DE)
(72) Erfinder: Forster, Josef, 84072 Haslach (DE); Ahlers, Roland, 85635 Siegertsbrunn (DE)
(74) Vertreter: Rupp, Christian

(56) Entgegenhaltungen:
- DE-U1-202007 013 457
- JP-U- H0 648 342
- US-A- 3 768 044
- US-A- 4 390 919
- US-A1- 2002 056 134
- US-B1- 6 636 404

## Beschreibung

Die Erfindung betrifft einen Begrenzer für breitbandige Hochfrequenzsignale, wie er insbesondere in Funkgeräten zum Einsatz kommt.

Je nach Abstand zwischen Sender und Empfänger kann der Empfangspegel eines Hochfrequenzsignals am Ort des Empfängers stark unterschiedliche Amplituden haben. Für den Fall, dass z.B. zwei Fahrzeuge mit je einem Funkgerät in unmittelbarer Nähe zueinander fahren, kann die Amplitude des Hochfrequenzsignals, welches von dem ersten Fahrzeug ausgesendet wird und unter anderem direkt von dem zweiten Fahrzeug empfangen wird, bei diesem sehr hoch sein. Um Beschädigungen in der Empfangsstufe des Funkgeräts zu vermeiden, werden daher Begrenzer eingesetzt, die das Hochfrequenzsignal begrenzen.

Aus der US 2010/0277839 A1 ist eine Schaltung bekannt, die einen an ihr angeschlossenen Schaltkreis vor einer zu hohen Amplitude eines Hochfrequenzsignals schützt. Die Schaltung besteht dabei aus einer Detektionseinheit, die ein Hochfrequenzsignals mit einem zu hohen Pegel erkennt, und aus einer Schaltereinheit, die aus PIN-Dioden (engl. positive intrinsic negative diode; dt. positiv intrinsische negative Diode) besteht, die das Hochfrequenzsignal in Abhängigkeit von dem von der Detektionseinheit ermittelten Ergebnis begrenzt. Nachteilig an der US 2010/0277839 A1 ist, dass der Schaltungsaufbau aufwendig ist und mit einer Detektionseinheit und einer Schalteinheit zwei verschiedene Schaltungsstufen benötigt. Dieser aktive Regelkreis ist auch aufgrund der verwendeten Regeltransistoren und der Erzeugung der Versorgungsspannungen für die Detektordioden und die Regeltransistoren sehr aufwendig.

Aus US 2002/056134 A1 ist ein Begrenzer für Hochfrequenzsignale mit den Merkmalen des Oberbegriffs des Anspruchs 1 bekannt. JP H06 48342 U offenbart ebenfalls einen Begrenzer für Hochfrequenzsignale.

Es ist daher die Aufgabe der vorliegenden Erfindung, einen Begrenzer für ein Hochfrequenzsignal, der die an ihn angeschlossene Schaltung zuverlässig gegen hohe Amplituden des Hochfrequenzsignals schützt und dabei sehr einfach aufgebaut ist und ein Funkgerät mit einem solchen Begrenzer zu schaffen.

Die Aufgabe wird bezüglich des erfindungsgemäßen Begrenzers für ein Hochfrequenzsignal durch die Merkmale des Anspruchs 1 und bezüglich des Funkgeräts durch die Merkmale des Anspruchs 9 gelöst. In den Unteransprüchen sind vorteilhafte Weiterbildungen des erfindungsgemäßen Begrenzers für ein Hochfrequenzsignal angegeben.

Der erfindungsgemäße Begrenzer für Hochfrequenzsignale weist einen Eingang auf, wobei ein Hochfrequenzsignal dem Begrenzer an seinem Eingang zugeführt ist. Der Begrenzer weist ebenfalls zumindest eine Begrenzungsstufe auf, die mit dem Eingang elektrisch verbunden ist. Die Begrenzungsstufe besteht aus einer Reihenschaltung mit einer nicht vorgespannten Diode und einer Zenerdiode, welche, anders als bei der US 2010/0277839 A1 nicht der Vorspannung der Diode dient, sodass das Hochfrequenzsignal über die eine nicht vorgespannte Diode und die Zenerdiode mit einer Bezugsmasse elektrisch verbunden ist. Im Gegensatz zur US 2010/0277839 A1 ist dies ein rein passiver Schaltkreis, der auch dann noch funktioniert, wenn die Versorgungsspannung abgeschaltet wird.

Es ist besonders vorteilhaft, dass die Begrenzerstufe aus einer Reihenschaltung besteht, die aus einer nicht vorgespannten Diode und Zenerdiode, welche nicht zur Vorspannung der Diode dient, aufgebaut ist, weil für die ordnungsgemäße Funktion keine weiteren Spannungsquellen notwendig sind, die von dem Hochfrequenzsignal entkoppelt werden müssten. Die Reihenschaltung zwischen der Diode und der Zenerdiode bewirkt, dass die hohe Kapazität der Zenerdiode durch die geringe Kapazität der Diode verringert wird, wodurch im nicht begrenzenden Betriebsfall die Einfügedämpfung gering gehalten werden kann. Der Einsatz der Reihenschaltung führt überdies dazu, dass die Begrenzung ab der Durchbruchspannung stärker zunimmt als bei Einsatz einer Zenerdiode alleine.

Im Weiteren besteht bei dem erfindungsgemäßen Begrenzer für Hochfrequenzsignale ein Vorteil, da das Hochfrequenzsignal an einer Anode einer ersten Diode in einer positiven Begrenzungsstufe anliegt und die Kathode der ersten Diode mit einer Kathode einer ersten Zenerdiode elektrisch verbunden ist und die Anode der ersten Zenerdiode mit der Bezugsmasse elektrisch verbunden ist, weil dadurch die positive Begrenzungsstufe eine positive Halbwelle des Hochfrequenzsignals begrenzt, und/oder das Hochfrequenzsignal an einer Kathode einer zweiten Diode einer negativen Begrenzungsstufe anliegt und eine Anode der zweiten Diode mit einer Anode einer zweiten Zenerdiode elektrisch verbunden ist und eine Kathode der zweiten Zenerdiode mit der Bezugsmasse elektrisch verbunden ist, weil dadurch eine negative Begrenzungsstufe eine negative Halbwelle des Hochfrequenzsignals begrenzt. Die zumindest eine Begrenzungsstufe kann folglich als positive Begrenzungsstufe oder als negative Begrenzungsstufe ausgebildet sein.

Weiterhin ist es besonders vorteilhaft, dass der Begrenzer einen Ausgang aufweist, wobei der Ausgang mit dem Eingang über ein Leitungsstück elektrisch verbunden ist und dass der Begrenzer zumindest zwei der positiven Begrenzungsstufen aufweist, die eine positive Halbwelle des Hochfrequenzsignals begrenzen und/oder dass der Begrenzer zumindest zwei der negativen Begrenzungsstufen aufweist, die eine negative Halbwelle des Hochfrequenzsignals begrenzen, wobei die zumindest zwei positiven Begrenzungsstufen, die die positive Halbwelle begrenzen, und/oder diezumindest zwei negativen Begrenzungsstufen, die die negative Halbwelle begrenzen an unterschiedlichen Verbindungsstellen des Leitungsstücks angeschlossen sind. Hierbei ist es besonders vorteilhaft, dass durch den Einsatz mehrerer paralleler Begrenzungsstufen eine höhere thermische Verlustleistung aufgenommen werden kann.

Die Begrenzung sollte in den folgenden Begrenzungsstufen bevorzugt ab einer niedrigeren Amplitude beginnen, als in der ersten Begrenzungsstufe, wenn die Begrenzungsstufen in etwa einem Viertel der Wellenlänge des Hochfrequenzsignals voneinander beabstandet sind. Auch wenn der Abstand nicht exakt einem Viertel der Wellenlänge entspricht, kann die Amplitude des Hochfrequenzsignals dennoch oberhalb der Durchbruchspannung liegen, sodass der Abstand derart gewählt ist, dass er bevorzugt ein Viertel der Wellenlänge entspricht, aber noch so groß ist, dass die vorliegende Amplitude des Hochfrequenzsignals zur Begrenzung durch die nachfolgende, also beabstandete, weitere Begrenzungsstufe führt.

Weiterhin besteht bei dem erfindungsgemäßen Begrenzer ein Vorteil, wenn in das Leitungsstück eine erste Induktivität geschalten ist, deren Höhe so gewählt ist, dass die Sperrschichtkapazität jeder Diode und jeder Zenerdiode innerhalb jeder Begrenzungsstufe für eine erste Betriebsfrequenz kompensiert ist.

Im Übrigen besteht bei dem erfindungsgemäßen Begrenzer ein Vorteil, wenn über zumindest einen ersten Schalter jeweils zumindest eine zusätzliche Induktivität zu der ersten Induktivität parallel oder in Serie zugeschalten ist, deren Höhe so gewählt ist, dass die Sperrschichtkapazität jeder Diode und jeder Zenerdiode innerhalb jeder Begrenzungsstufe für eine andere Betriebsfrequenz kompensiert ist. Dies erlaubt, dass mehrere zusätzliche Induktivitäten hinzuschaltbar sind, sodass der Einfluss der Dioden und der Zenerdioden bei verschiedenen Betriebsfrequenzen kompensiert ist.

Weiterhin besteht bei dem erfindungsgemäßen Begrenzer ein

Vorteil, dass über zumindest einen zweiten Schalter zumindest eine Begrenzungsstufe mit einem Leitungsstück elektrisch trennbar verbunden ist. Dies erlaubt, dass mehrere Begrenzungsstufen zusätzlich hinzugeschalten werden können. Diese weiteren Begrenzungsstufen, die elektrisch zuschaltbar sind, können das Hochfrequenzsignal z.B. auf eine noch niedrigere Amplitude begrenzen. Hierzu können in diesen Begrenzungsstufen Zenerdioden verwendet werden, die gegenüber den Zenerdioden eine niedrigere Durchbruchspannung haben, die in den Begrenzungsstufen eingesetzt sind, die fest mit dem Leitungsstück verbunden sind. Der Schalter kann auch dann geschlossen werden, wenn die thermische Belastung der übrigen Begrenzungsstufen erreicht ist, oder damit die vorhandenen Induktivitäten und Sperrschichtkapazitäten für wieder eine andere Betriebsfrequenz kompensiert werden. Bei den Schaltern handelt es sich dabei z.B. um PIN-Dioden oder auch um mechanische Schalter, die z.B. manuell betätigt werden können.

Außerdem ist es bei dem erfindungsgemäßen Begrenzer besonders vorteilhaft, wenn es sich bei jeder Diode um eine PIN-Diode handelt, weil die Sperrschichtkapazitäten einer PIN-Diode sehr niedrig sind. Es ist auch besonders vorteilhaft, wenn die Diode und/oder die Zenerdiode eine MELF-Bauform (engl. metall electrode faces; dt. metallene Elektrodenfront) aufweisen, weil diese dadurch besonders einfach gekühlt werden können und eine große Widerstandsfähigkeit gegenüber hohen Temperaturen haben. Es ist dabei auch vorteilhaft, wenn der Begrenzer eine Leiterplatte beinhaltet, auf der die zumindest eine Begrenzungsstufe angeordnet ist, weil dies den Aufbau deutlich erleichtert und die Produktion weitestgehend automatisiert erfolgen kann.

Der erfindungsgemäße Begrenzer kann dabei innerhalb eines Funkgeräts, welches zusätzlich mit einer Antenne verbunden ist, angeschlossen werden. Der Begrenzer arbeitet auch dann, wenn das Funkgerät von der Stromversorgung getrennt ist. Ein solches Funkgerät kann beispielsweise in einem Fahrzeug aber auch in einem Flugzeug oder einem Schiff installiert sein.

Verschiedene Ausführungsbeispiele werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein Übersichtsschaltbild eines Teils eines Funkgeräts, das den erfindungsgemäßen Begrenzer für breitbandige Hochfrequenzsignale aufweist;
- Fig. 2A: einen Begrenzer, der eine Begrenzungsstufe aufweist, die eine positive Halbwelle des Hochfrequenzsignals begrenzt;
- Fig. 2B: einen weiteren Begrenzer, der eine Begrenzungsstufe aufweist, die eine positive Halbwelle des Hochfrequenzsignals begrenzt;
- Fig. 3A: einen Begrenzer, der zwei Begrenzungsstufen aufweist, die eine positive Halbwelle und eine negative Halbwelle des Hochfrequenzsignals begrenzen;
- Fig. 3B: einen Begrenzer, der sechs parallel angeordnete Begrenzungsstufen aufweist, die eine positive Halbwelle und eine negative Halbwelle des Hochfrequenzsignals begrenzen;
- Fig. 4A: einen Begrenzer, der sechs parallel angeordnete Begrenzungsstufen aufweist, die eine positive Halbwelle und eine negative Halbwelle des Hochfrequenzsignals begrenzen, und der zusätzlich eine Induktivität zur Kompensation beinhaltet;
- Fig. 4B: einen weiteren Begrenzer, der sechs parallel angeordnete Begrenzungsstufen aufweist, die eine positive Halbwelle und eine negative Halbwelle des Hochfrequenzsignals begrenzen, und der zusätzlich mehrere Induktivitäten zur Kompensation beinhaltet, die über einen Schalter zu- und wegschaltbar sind; und
- Fig. 4C: einen erfindungsgemäßen Begrenzer, der sechs parallel angeordnete Begrenzungsstufen aufweist, die eine positive Halbwelle und eine negative Halbwelle des Hochfrequenzsignals begrenzen, von denen zumindest zwei Begrenzungsstufen zu- und weggeschaltet werden können und der zusätzlich mehrere Induktivitäten zur Kompensation beinhaltet, die über einen Schalter zu- und wegschaltbar sind.

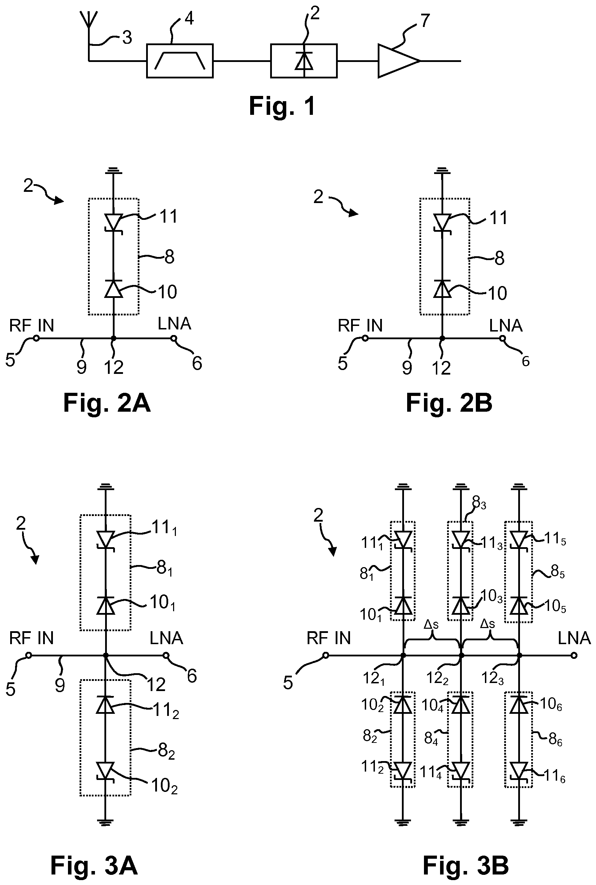

Fig. 1 zeigt ein Übersichtschaltbild eines Teils eines Funkgeräts 1, das den erfindungsgemäßen Begrenzer 2 für breitbandige Hochfrequenzsignale aufweist. Eine Antenne 3 ist dabei mit einem Begrenzer 2 über einen Bandpass 4 verbunden. Die Antenne 3 kann optional auch direkt mit einem Eingang 5 des Begrenzers 2 verbunden sein. Ein Ausgang 6 des Begrenzers 2 ist bevorzugt mit einem rauscharmen Verstärker (engl. low-noise amplifier (LNA)) 7 verbunden. Der Begrenzer 2 dient dazu, hohe Amplituden innerhalb des von der Antenne 3 empfangenen Hochfrequenzsignals auf eine Amplitude zu begrenzen, die für die nachfolgende Elektronik unschädlich ist. Dies ist insbesondere dann relevant, wenn ein Sender nahe an einem Empfänger angeordnet ist. Bevorzugt soll der erfindungsgemäße Begrenzer 2 dabei ohne eine zusätzliche Stromzufuhr arbeiten, sodass auch bei einem ausgeschalteten Funkgerät 1 die Elektronik vor einem zu hohen Pegelwert geschützt ist.

Fig. 2A zeigt einen Begrenzer 2, der eine Begrenzungsstufe 8 enthält. Gut zu erkennen ist, dass der Eingang 5 mit dem Ausgang 6 über ein Leitungsstück 9 elektrisch verbunden ist. Bei dem Leitungsstück 9 kann es sich um eine Leiterbahn auf einer Platine handeln, auf welcher der Begrenzer 2 aufgebaut ist. Bei dem Leitungsstück 9 kann es sich allerdings auch um ein Kabel, eine Litze oder um einen einfachen Draht handeln.

Der Begrenzer 2 weist zumindest eine Begrenzungsstufe 8 auf. Diese zumindest eine Begrenzungsstufe 8 besteht aus einer Reihenschaltung aus genau einer Diode 10 und genau einer Zenerdiode 11. Die Diode 10 ist dabei nicht vorgespannt. Die Zenerdiode 11 dient auch nicht zur Vorspannung der Diode 10. Die Begrenzungsstufe 8 ist dabei einerseits mit dem Leitungsstück 9 und damit mit dem Eingang 5 und dem Hochfrequenzsignal verbunden. Andererseits ist die Begrenzungsstufe 8 ebenfalls mit der Bezugsmasse verbunden.

Wie bereits erläutert, besteht die Begrenzungsstufe 8 aus einer Reihenschaltung bestehend aus einer Diode 10 und einer Zenerdiode 11. Weitere Bauteile sind in der Begrenzungsstufe 8 nicht enthalten. Insbesondere sind innerhalb der Reihenschaltung oder an der Reihenschaltung, die aus der Diode 10 und der Zenerdiode 11 besteht keine weiteren Elemente in Reihe angeschlossen. Ebenfalls sind innerhalb der Reihenschaltung oder an der Reihenschaltung keine weiteren Elemente parallel dazu angeschlossen, außer weiteren Begrenzungsstufen 8, wie später noch ausführlich erläutert wird. Bei den Elementen handelt es sich einerseits um aktive Bauteile, insbesondere Transistoren, die nicht in Reihe zu der Begrenzungsstufe geschalten sind, aber auch um passive Bauteile, wie z.B. Kondensatoren, die parallel zu der Begrenzungsstufe geschalten sind.

Die Begrenzungsstufe 8 kann sowohl eine positive Halbwelle des Hochfrequenzsignals begrenzen, als auch eine negative Halbwelle des Hochfrequenzsignals. Für den Fall, dass die Begrenzungsstufe 8 eine positive Halbwelle begrenzt, wird nachfolgend auch von einer positiven Begrenzungsstufe 8 gesprochen. Für den Fall dass die Begrenzungsstufe eine negative Halbwelle begrenzt, wird nachfolgend auch von einer negativen Begrenzungsstufe gesprochen. Für den Fall, dass einzig von einer Begrenzungsstufe gesprochen wird, kann es sich bei dieser um eine solche handeln, die entweder eine positive Halbwelle oder eine negative Halbwelle begrenzt.

Bei dem Ausführungsbeispiel aus Fig. 2A ist eine Begrenzungsstufe 8 gezeigt, die die positive Halbwelle des Hochfrequenzsignals begrenzen kann. In diesem Fall wird über den Eingang 5 des Begrenzers 2 das Hochfrequenzsignal zugeführt, welches an dem Leitungsstück 9 anliegt. Die Begrenzungsstufe 8 ist ebenfalls über eine Verbindungsstelle 12 mit dem Leitungsstück 9 verbunden. Bei der Verbindungsstelle 12 kann es sich um eine einfache Abzweigung der Leiterbahn auf der Platine handeln oder es kann mittels einer Löt- oder Schweißverbindung ein Draht bzw. eine Litze an dem Leitungsstück 9 befestigt sein.

Die erste Diode 10 und die erste Zenerdiode 11 sind dabei so angeordnet, dass das Hochfrequenzsignal an einer Anode der genau einen ersten Diode 10 der zumindest einen positiven Begrenzungsstufe 8 anliegt. Eine Kathode der ersten Diode 10 ist dabei mit einer Kathode der ersten Zenerdiode 11 elektrisch verbunden. Eine Anode der ersten Zenerdiode 11 ist mit der Bezugsmasse elektrisch verbunden.

Die erste Zenerdiode 11 sorgt dafür, dass das Hochfrequenzsignal durch den Begrenzer 2, nicht bereits ab einer Amplitude von ca. 0,7 Volt für Siliziumdioden auf diese begrenzt wird. Die erste Diode 10 und die erste Zenerdiode 11 sind dabei derart gewählt, dass der Begrenzer 2 eine Amplitude des Hochfrequenzsignals bei ca. 7-8 Volt abschaltet. Dadurch wird ein Schutz vor einer zu hohen einfallenden Hochfrequenzleistung, sowie zusätzlich vor Überspannungen, erreicht. Ein abgeschnittenes Sinus-Signal nimmt dabei eine trapezartige Form an. Die erste Zenerdiode 11 hat dabei den Vorteil, dass die Ausgangsleistung des Hochfrequenzsignals, als auch der Streuverlust, den vorgegebenen Spezifikationen entspricht, weil ihre Kennlinie bei ihrer spezifizierten Spannung stark abknickt. Eine zusätzliche erste Diode 10 erhöht dabei den Dämpfungsfaktor.

Der Begrenzer 2 nimmt dabei nur einen Teil der abgeschnittenen Halbwelle als Energie direkt auf. Vielmehr wird der überwiegende Teil am Übergangspunkt zur Bezugsmasse wieder reflektiert und über die Antenne 3 abgestrahlt. Dabei werden ca. 90 % der Energie reflektiert und nur ca. 10 % absorbiert.

Fig. 2B zeigt einen weiteren Begrenzer 2 der eine Begrenzungsstufe 8 aufweist, die eine positive Halbwelle des Hochfrequenzsignals begrenzt. Im Unterschied zu dem Begrenzer aus Fig. 2A handelt es sich bei der ersten Diode 10 in Fig. 2B um eine PIN-Diode 10. Die Sperrschichtkapazität einer solchen PIN-Diode 10 ist deutlich niedriger als die Sperrschichtkapazität einer herkömmlichen Diode.

Fig. 3A zeigt einen Begrenzer 2, der zwei Begrenzungsstufen 8₁, 8₂ aufweist, die eine positive Halbwelle und eine negative Halbwelle des Hochfrequenzsignals begrenzen.

Eine positive Begrenzungsstufe 8₁ begrenzt dabei eine positive Halbwelle des Hochfrequenzsignals. Diese besteht, wie bereits erläutert, aus einer Reihenschaltung aus genau einer erste Diode 10₁ und genau einer ersten Zenerdiode 11₁. Bei der ersten Diode 10₁ handelt es sich bevorzugt um eine erste PIN-Diode 10₁.

Die negative Begrenzungsstufe 8₂ begrenzt dabei eine negative Halbwelle des Hochfrequenzsignals. Die negative Begrenzungsstufe 8₂ ist dabei über die Verbindungsstelle 12 mit dem Leitungsstück 9 verbunden. Das Hochfrequenzsignal liegt dadurch an einer Kathode einer zweiten Diode 10₂ der negativen Begrenzungsstufe 8₂ für die negative Halbwelle an. Eine Anode der zweiten Diode 10₂ ist dabei mit einer Anode einer zweiten Zenerdiode 11₂ elektrisch verbunden. Eine Kathode der zweiten Zenerdiode 11₂ der zumindest einen negativen Begrenzungsstufe 8₂ für die negative Halbwelle ist dabei mit der Bezugsmasse elektrisch verbunden. Bei der zweiten Diode 10₂ handelt es sich ebenfalls bevorzugt um eine zweite PIN-Diode 10₂. Beide Dioden 10₂ und 11₂ weisen bevorzugt eine MELF-Bauform auf. Auch die negative Begrenzungsstufe 8₂ für die negative Halbwelle des Hochfrequenzsignals absorbiert nur einen Teil der Energie der negativen Halbwelle. Die meiste Energie wird ebenfalls an der Bezugsmasse reflektiert und über die Antenne 3 abgestrahlt.

Fig. 3B zeigt einen Begrenzer 2, der sechs parallel angeordnete Begrenzungsstufen 8₁, 8₂, 8₃, 8₄, 8₅, 8₆ aufweist, die eine positive Halbwelle und eine negative Halbwelle des Hochfrequenzsignals begrenzen. In dem Ausführungsbeispiel aus Fig. 3B begrenzen die positiven Begrenzungsstufen 8₁, 8₃, 8₅ die positive Halbwelle des Hochfrequenzsignals, wohingegen die negativen Begrenzungsstufen 8₂, 8₄ und 8₆ die negative Halbwelle des Hochfrequenzsignals begrenzen. Bezüglich des Aufbaus der Begrenzungsstufen 8₁ bis 8₆ wird auf die vorangegangenen Zeichnungsfiguren verwiesen.

Gut zu erkennen ist, dass der Begrenzer 2 zumindest zwei positive Begrenzungsstufen 8₁, 8₃, 8₅, in diesem Fall sogar drei, aufweist, die eine positive Halbwelle des Hochfrequenzsignals begrenzen. Es ist ebenfalls gut ersichtlich, dass der Begrenzer 2 ebenfalls zumindest zwei negative Begrenzungsstufen 8₂, 8₄, 8₆, in diesem Fall sogar drei, aufweist, die eine negative Halbwelle des Hochfrequenzsignals begrenzen. Es ist dabei offensichtlich, dass der Begrenzer 2 für jede Halbwelle (positiv, negativ) des Hochfrequenzsignals nicht nur eine, oder zwei, oder drei, oder vier, oder fünf, sondern n Begrenzungsstufen (8₁, 8₂ bis 8ₙ) aufweisen kann, wobei n ganzzahlig ist. Gut zu erkennen ist außerdem, dass die zumindest zwei positiven Begrenzungsstufen 8₁, 8₃ und 8₅, in diesem Fall drei, die die positive Halbwelle begrenzen und/oder dass die zumindest zwei negativen Begrenzungsstufen 8₂, 8₄ und 8₆, in diesem Fall drei, die die negative Halbwelle begrenzen, an unterschiedlichen Verbindungsstellen 12₁, 12₂, 12₃ des Leitungsstücks 9 angeschlossen sind. In dem Ausführungsbeispiel aus Fig. 3B sind die Begrenzungsstufen 8₁, 8₂ mit der Verbindungsstelle 12₁ des Leitungsstücks 9 verbunden. Die Begrenzungsstufen 8₃ und 8₄ sind dabei mit der Verbindungsstelle 12₂ des Leitungsstücks 9 verbunden. Im Weiteren sind die Begrenzungsstufen 8₅ und 8₆ mit der Verbindungsstelle 12₃ verbunden.

Gut zu erkennen ist, dass die einzelnen Verbindungsstellen 12₁, 12₂ und 12₃ um die Länge Δs voneinander beabstandet sind. Dabei ist die Verbindungsstelle 12₂ von der Verbindungsstelle 12₁ und der Verbindungsstelle 12₃ jeweils um den Abstand Δsentfernt. Der Abstand Δszwischen jeder Verbindungsstelle 12₁, 12₂, 12₃ beträgt dabei bevorzugt ein Viertel der Wellenlänge des Hochfrequenzsignals. Für den Fall, dass die Begrenzungsstufe 8₁ eine positive Halbwelle des Hochfrequenzsignals begrenzt, wird die Spannung an der Verbindungsstelle 12₁ auf das Bezugsmassepotenzial heruntergezogen.

Im Abstand von λ/4 findet sich abermals ein Maximum in der Amplitude des Hochfrequenzsignals. Dies erlaubt, dass die Begrenzungsstufe 8₃ oder 8₄ begrenzend wirken. Für den Fall, dass die Frequenz niedrig ist, kann der geforderte Abstand zwischen jeder Verbindungsstelle 12₁ bis 12₃ allerdings nicht eingehalten werden, sodass an der nächsten Verbindungsstelle 12₂, 12₃ nicht unbedingt wieder ein Maximum in der Amplitude des Hochfrequenzsignals auftritt, die Amplitude allerdings dennoch über einer Schwellwert liegt, ab dem die Zenerdiode 11₁ bis 11₆ durchzündet.

Der Abstand der einzelnen Verbindungsstellen 12₁, 12₂ und 12₃ kann auch in etwa null Wellenlängen betragen. Dies ist z.B. für niedrige Frequenzen möglich. In diesem Fall werden Beca. 50 % der Energie durch die Begrenzungsstufen 8₁, 8₃, 8₅ oder 8₂, 8₄, 8₆ reflektiert, ca. 30 % der Energie absorbiert und ca. 20 % der Energie transmittiert.

Gut zu sehen ist ebenfalls, dass bevorzugt an jeder Verbindungsstelle 12₁ bis 12₃ eine positive Begrenzungsstufe 8₁, 8₃, 8₅ angeschlossen ist, die eine positive Halbwelle des Hochfrequenzsignals begrenzt und dass an jeder Verbindungsstelle 12₁ bis 12₃ weiterhin eine negative Begrenzungsstufe 8₂, 8₄, 8₆ angeschlossen ist, die eine negative Halbwelle des Hochfrequenzsignals begrenzt. Jede Begrenzungsstufe 8₁ bis 8₆ kann allerdings auch an einer separaten, also eigenen Verbindungsstelle 12₁ bis 12₃ angeschlossen sein. Insgesamt kann es also so viele Verbindungsstellen geben, wie es Begrenzungsstufen 8₁ bis 8₆ gibt.

Damit beim Durchbruch einer Zenerdiode 11₁ bis 11₆ möglichst auch die Zenerdiode 11₁ bis 11₆ der benachbarten Begrenzungsstufe 8₁ bis 8₆ ebenfalls durchbricht, wird empfohlen, die Zenerdioden 11₁ bis 11₆ und/oder die Dioden 10₁ bis 10₆ möglichst nahe zueinander anzuordnen. In dem Beispiel aus Fig. 3B sollten die ersten Zenerdioden 11₁, 11₃ und 11₅ und/oder die ersten Dioden 10₁, 10₃ und 10₅ möglichst nahe beieinander angeordnet sein. Gleichermaßen sollten die zweiten Zenerdioden 11₂, 11₄ und 11₆ und/oder die zweiten Dioden 10₂, 10₄ und 10₆ ebenfalls nahe beieinander angeordnet sein. Nahe zueinander angeordnet sein bedeutet hier, dass die thermische Verlustleistung in einer Diode 10₁ bis 10₆ und/oder einer Zenerdiode 11₁ bis 11₆ die benachbarte/n Diode/n 10₁ bis 10₆ und/oder Zenerdiode/n 11₁ bis 11₆ soweit aufheizt, dass diese ebenfalls durchzünden.

Dadurch, dass mehrere positive Begrenzungsstufen 8₁, 8₃ und 8₅, sowie negative Begrenzungsstufen 8₂, 8₄ und 8₆ des jeweils gleichen Typs parallel angeordnet sind, kann eine höhere Verlustleistung aufgenommen werden. Die Anordnung aus Fig. 3B kann beispielsweise problemlos Leistungen von bis zu 10 Watt kontinuierlich reflektieren. Dabei werden bis zu 90 % reflektiert und maximal 2 Watt absorbiert. Durch Wahl anderer Zenerdioden 11₁ bis 11₆ und/oder anderer PIN-Dioden 10₁ bis 10₆ können diese Werte allerdings verschoben werden.

Der Begrenzer 2 weist außerdem auch ein nicht dargestelltes Gappad auf, welches zur Wärmeabfuhr möglichst luftdicht auf der zumindest einen Begrenzungsstufe 8, am besten auf allen Begrenzungsstufen 8₁ bis 8₆, angeordnet ist. Das Gappad wird dabei bevorzugt mit einem Kleber auf den Begrenzungsstufen 8₁ bis 8₆ befestigt.

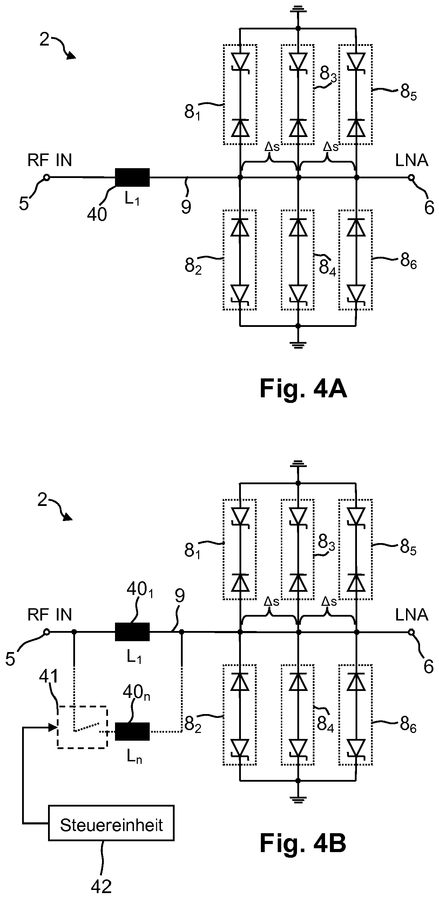

Fig. 4A zeigt einen Begrenzer 2, der sechs parallel angeordnete Begrenzungsstufen 8₁ bis 8₆ aufweist, die eine positive Halbwelle und eine negative Halbwelle des Hochfrequenzsignals begrenzen, und der zusätzlich eine erste Induktivität 40 zur Kompensation beinhaltet. Die erste Induktivität 40 ist dabei einerseits mit dem Eingang 5 und andererseits mit dem Leitungsstück 9 verbunden. Man kann auch sagen, dass die erste Induktivität 40 in das Leitungsstück 9 geschaltet ist. Die erste Induktivität 40 kann auch mit dem Ausgang 6 einerseits und dem Leitungsstück 9 andererseits verbunden sein. Die Höhe der ersten Induktivität 40 ist dabei bevorzugt so gewählt, dass die Sperrschichtkapazität jeder Diode 10₁ bis 10₆ und jeder Zenerdiode 11₁ bis 11₆ innerhalb jeder Begrenzungsstufe 8₁ bis 8₆ für eine erste Betriebsfrequenz kompensiert ist. Für den Fall, dass es sich bei dem Hochfrequenzsignal um ein breitbandiges Signal handelt, wird die Höhe der ersten Induktivität 40 bevorzugt derart gewählt, dass die Sperrschichtkapazitäten für die Mittenfrequenz des Hochfrequenzsignals kompensiert sind. Die erste Induktivität 40 wird dabei bevorzugt ebenfalls auf den als Platine ausgebildeten Begrenzer 2 gelötet. Die erste Induktivität 40 kann auch durch die Führung der Leiterbahn auf der Platine gebildet sein. Eine mäanderförmige Leiterbahnstruktur erhöht dabei die Induktivität der Leiterbahn.

Fig. 4B zeigt einen weiteren Begrenzer 2, der sechs parallel angeordnete Begrenzungsstufen 8₁ bis 8₆ aufweist, die eine positive Halbwelle und eine negative Halbwelle des Hochfrequenzsignals begrenzen, und der zusätzlich mehrere Induktivitäten 40ₙ zur Kompensation beinhaltet, die über einen Schalter 41 zu- und wegschaltbar sind. In dem Ausführungsbeispiel der Fig. 4B ist die erste Induktivität 40₁ mit dem Eingang 5 des Begrenzers 2 und mit dem Leitungsstück 9 verbunden. Parallel zu dieser ersten Induktivität 40₁ sind n weitere Induktivitäten 40ₙ, mit n ≥ 1 und ganzzahlig, zu-oder wegschaltbar. Dabei können die weiteren n Induktivitäten einzeln oder gemeinsam mit einem Schalter 41 zu der ersten Induktivität 40₁ hinzugeschaltet oder von dieser weggeschaltet werden. Der Schalter 41 wird dabei z.B. von einer Steuereinheit 42 bedient. Der Schalter 41 kann z.B. mittels einer PIN-Diode aufgebaut sein. Es ist ebenfalls möglich, dass es sich bei dem Schalter 41 um einen manuellen Schalter handelt, der von einem Benutzer manuell eingestellt wird. In diesem Fall kann der Begrenzer 2 die Sperrschichtkapazitäten sämtlicher Begrenzerstufen 8₁ bis 8₆ auch für eine andere Betriebsfrequenz kompensieren, selbst wenn alle Spannungsquellen im Funkgerät 1 ausgeschaltet sind. Durch Zuschalten von einer oder einigen oder allen der zusätzlich parallel angebrachten Induktivitäten 40ₙ können die Sperrschichtkapazitäten der Begrenzerstufen 8₁ bis 8₆ für weitere bzw. andere Betriebsfrequenzen kompensiert werden.

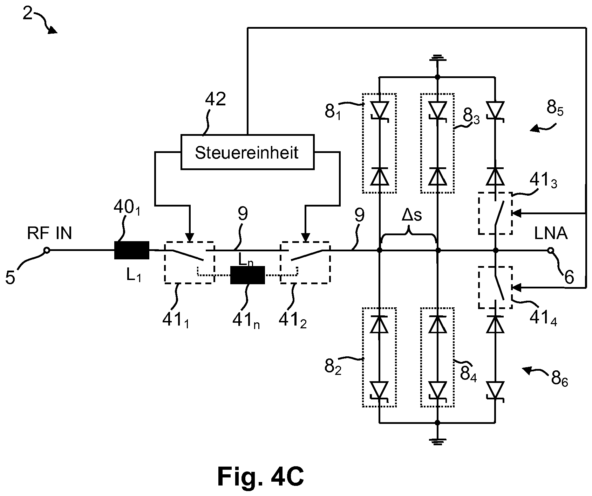

Fig. 4C zeigt einen erfindungsgemäßen Begrenzer 2, der sechs parallel angeordnete Begrenzungsstufen 8₁ bis 8₆ aufweist, die eine positive Halbwelle und eine negative Halbwelle des Hochfrequenzsignals begrenzen, wobei zumindest zwei Begrenzungsstufen 8₅, 8₆ zu- und weggeschaltet werden können und wobei der erfindungsgemäße Begrenzer 2 zusätzlich mehrere Induktivitäten 40ₙ zur Kompensation beinhaltet, die über Schalter 41₁, 41₂, 41₃, 41₄ zu- und wegschaltbar sind. Gut zu erkennen ist, dass der erfindungsgemäße Begrenzer 2 eine erste Induktivität 40₁ und zumindest eine weitere Induktivität 40ₙ aufweist, die in dem Ausführungsbeispiel aus Fig. 4C in Serie schaltbar sind. Bei der zumindest einen weiteren Induktivität 40ₙ handelt es sich um eine oder mehrere Einzel-Induktivitäten. Die zumindest eine weitere Induktivität 40ₙ kann über die beiden Schalter 41₁ und 41₂ in Serie zu der ersten Induktivität 40₁ geschalten werden. Für den Fall, dass die Induktivität 40ₙ aus einer Vielzahl von einzelnen Induktivitäten besteht, kann über die Schalter 41₁ und 41₂ eine dieser Induktivitäten oder mehrere dieser Induktivitäten oder alle dieser Induktivitäten 40ₙ in Serie zu der ersten Induktivität 40₁ geschalten werden.

Es ist dabei offensichtlich, dass die weiteren Induktivitäten 40ₙ nicht nur in Serie zu der ersten Induktivität 40₁ geschalten werden können, sondern gleichzeitig auch noch zusätzlich parallel zu der ersten Induktivität 40₁, wie dies in Fig. 4B bereits erläutert wurde.

Im Weiteren können in dem erfindungsgemäßen Begrenzer 2 aus Fig. 4C die zumindest je eine Begrenzungsstufe 8₅, 8₆, die zur Begrenzung der positiven und der negativen Halbwelle dienen, zu dem Hochfrequenzsignalleitungsstück 9 hinzugeschalten oder diesem weggeschalten werden. Beispielsweise kann die positive Begrenzungsstufe 8₅ mittels des Schalters 41₃ elektrisch mit dem Leitungsstück 9 verbunden werden oder von diesem getrennt werden. Gleiches gilt für die negative Begrenzungsstufe 8₆, welche über den Schalter 41₄ elektrisch mit dem Leitungsstück 9 verbunden oder von diesem elektrisch getrennt werden kann.

Es ist ebenfalls möglich, dass noch weitere Begrenzungsstufen 8₁ bis 8₆ bzw. bis 8ₙ mittels Schalter zu dem Leitungsstück 9 hinzuschaltbar sind. Sämtliche Schalter 41₁ bis 41₄ können z.B. durch PIN-Dioden aufgebaut sein und von der Steuereinheit 42 gesteuert werden. Die Schalter 41₁ bis 41₄ können auch aus manuellen Schaltbrücken bestehen, die von einem Benutzer eingestellt werden. Dies erlaubt, dass die Sperrschichtkapazitäten der einzelnen Begrenzungsstufen 8₁ bis 8₆ auch ohne Energieversorgung dauerhaft für eine Vielzahl von Betriebsfrequenzen kompensiert werden können.

Im Übrigen wäre es auch möglich, dass innerhalb jeder Begrenzungsstufe direkt eine passende Kompensationsinduktivität integriert wäre. Allerdings wäre in diesem Fall das Nachstellen für unterschiedliche Betriebsfrequenzen nicht mehr möglich.

Der erfindungsgemäße Begrenzer 2 funktioniert dabei in einem Temperaturbereich von -40°C bis +85°C problemlos. Der erfindungsgemäße Begrenzer 2 wird bevorzugt mittels einer Leiterplatte aufgebaut. Neben dem bereits erwähnten Gappad können direkt unterhalb der Dioden 10₁ bis 10₆ und/oder direkt unterhalb der Zenerdioden 11₁ bis 11₆ Aussparungen in der Leiterplatte vorhanden sein, in die direkt ein Kupferinlay (dt. Kupfereinlage) eingepresst wird, welches den Wärmeübergangswiderstand weiter senkt. Der dargestellte erfindungsgemäße Begrenzer 2 ist bevorzugt direkt in einem Chip integriert. Dadurch wird ein geringerer Platzbedarf benötigt und die Wärmeabfuhr verbessert. Die Leistungsaufteilung kann auf die einzelnen Elemente besser verteilt werden.

Bevorzugt sind im Übrigen alle positiven Begrenzungsstufen 8₁, 8₃, 8₅, die die positiven Halbwellen des Hochfrequenzsignals begrenzen, gleich aufgebaut. Selbiges gilt ebenfalls für alle negativen Begrenzungsstufen 8₂, 8₄, 8₆, die die negative Halbwelle des Hochfrequenzsignals begrenzen. Es ist allerdings ebenfalls möglich, dass einzelne Begrenzungsstufen 8₁ bis 8₆ unterschiedliche Dioden 10₁ bis 10₆ und/oder unterschiedliche Zenerdioden 11₁ bis 11₆ aufweisen, die z.B. unterschiedliche Durchbruchspannungen besitzen und/oder unterschiedliche Energien absorbieren können.

Die Begrenzungsstufen können in einer nicht erfindungsgemäßen Variante auch derart aufgebaut sein, dass die Position der Dioden 10₁ bis 10₆ und der Zenerdioden 11₁ bis 11₆ vertauscht sind. In diesem Fall werden die Zenerdioden 11₁ bis 11₆ über die Verbindungsstellen 12₁ bis 12₃ mit dem Leitungsstück 9 elektrisch verbunden, wohingegen die Dioden 10₁ bis 10₆ mit der Bezugsmasse elektrisch verbunden sind.

Die Erfindung ist durch die Ansprüche definiert.

## Patentansprüche

1. Begrenzer (2) für Hochfrequenzsignale aufweisend einen Eingang (5), wobei ein Hochfrequenzsignal dem Begrenzer (2) an seinem Eingang (5) zugeführt ist, wobei der Begrenzer (2) zumindest eine Begrenzungsstufe (8; 8₁, 8₂, 8₃, 8₄, 8₅, 8₆) aufweist, die mit dem Eingang (5) elektrisch verbunden ist,
wobei die Begrenzungsstufe (8; 8₁, 8₂, 8₃, 8₄, 8₅, 8₆) eine Reihenschaltung mit einer nicht vorgespannten Diode (10; 10₁, 10₂, 10₃, 10₄, 10₅, 10₆) und einer Zenerdiode (11; 11₁, 11₂, 11₃, 11₄, 11ₛ, 11₆), welche nicht der Vorspannung der Diode dient, enthält, sodass das Hochfrequenzsignal über die eine nicht vorgespannte Diode (10; 10₁, 10₂, 10₃, 10₄, 10₅, 10₆) und die Zenerdiode (11; 11₁, 11₂, 11₃, 11₄, 11ₛ, 11₆) mit einer Bezugsmasse elektrisch verbunden ist, und
wobei das Hochfrequenzsignal an einer Anode einer ersten Diode (10; 10₁, 10₃, 10₅) in zumindest einer positiven Begrenzungsstufe (8; 8₁, 8₃, 8₅) anliegt und eine Kathode der ersten Diode (10; 10₁, 10₃, 10₅) mit einer Kathode einer ersten Zenerdiode (11; 11₁, 11₃, 11₅) elektrisch verbunden ist und eine Anode der ersten Zenerdiode (11; 11₁, 11₃, 11₅) mit der Bezugsmasse elektrisch verbunden ist, wodurch die zumindest eine positive Begrenzungsstufe (8; 8₁, 8₃, 8₅) eine positive Halbwelle des Hochfrequenzsignals begrenzt, und/oder das Hochfrequenzsignal an einer Kathode einer zweiten Diode (10₂, 10₄, 10₆) in zumindest einer negativen Begrenzungsstufe (8₂, 8₄, 8₆) anliegt und eine Anode der zweiten Diode (10₂, 10₄, 10₆) mit einer Anode einer zweiten Zenerdiode (11₂, 11₄, 11₆) elektrisch verbunden ist und eineKathode der zweiten Zenerdiode (11₂, 11₄, 11₆) mit der Bezugsmasse elektrisch verbunden ist, wodurch die zumindest eine negative Begrenzungsstufe (8₂, 8₄, 8₆) eine negative Halbwelle des Hochfrequenzsignals begrenzt,
wobei der Begrenzer die Dioden nicht vorspannt, und
wobei der Begrenzer (2) einen Ausgang (6) aufweist, wobei der Ausgang mit dem Eingang (5) über ein Leitungsstück (9) elektrisch verbunden ist,
**dadurch gekennzeichnet,**
**dass** der Begrenzer (2) zumindest zwei der positiven Begrenzungsstufen (8; 8₁, 8₃, 8₅) aufweist, die eine positive Halbwelle des Hochfrequenzsignals begrenzen und/oder dass der Begrenzer (2) zumindest zwei der negativen Begrenzungsstufen (8₂, 8₄, 8₆) aufweist, die eine negative Halbwelle des Hochfrequenzsignals begrenzenwobei die zumindest zwei positiven Begrenzungsstufen (8; 8₁, 8₃, 8₅), die die positive Halbwelle begrenzen an unterschiedlichen Verbindungsstellen (12; 12₁, 12₂, 12₃) des Leitungsstücks (9) angeschlossen sind und/oder die zumindest zwei negativen Begrenzungsstufen (8₂, 8₄, 8₆), die die negative Halbwelle begrenzen an unterschiedlichen Verbindungsstellen (12; 12₁, 12₂, 12₃) des Leitungsstücks (9) angeschlossen sind; und dass über zumindest einen Schalter (41₃, 41₄) die zumindest eine Begrenzungsstufe (8; 8₁, 8₂, 8₃, 8₄, 8₅, 8₆) mit dem Leitungsstück (9) trennbar verbunden ist.

2. Begrenzer nach Anspruch 1, **dadurch gekennzeichnet,**
**dass** die zumindest zwei positiven Begrenzungsstufen (8; 8₁, 8₃, 8₅), die eine positive Halbwelle des Hochfrequenzsignals begrenzen, gleich aufgebaut sind und/oder
**dass** die zumindest zwei negativen Begrenzungsstufen (8₂, 8₄, 8₆), die eine negative Halbwelle des Hochfrequenzsignals begrenzen, gleich aufgebaut sind.

3. Begrenzer nach einem der Ansprüche 1 oder 2,
**dadurch gekennzeichnet,**
**dass** an jeder Verbindungsstelle (12; 12₁, 12₂, 12₃) eine positive Begrenzungsstufe (8; 8₁, 8₃, 8₅) angeschlossen ist, die eine positive Halbwelle des Hochfrequenzsignals begrenzt, und
**dass** an jeder Verbindungsstelle (12; 12₁, 12₂, 12₃) weiterhin eine negative Begrenzungsstufe (8₂, 8₄, 8₆) angeschlossen ist, die eine negative Halbwelle des Hochfrequenzsignals begrenzt.

4. Begrenzer nach einem der Ansprüche 1 bis 3,
**dadurch gekennzeichnet,**
**dass** in das Leitungsstück (9) eine erste Induktivität (40; 40₁) geschalten ist, deren Höhe so gewählt ist, dass die Sperrschichtkapazität jeder Diode (10; 10₁, 10₂, 10₃, 10₄, 10₅, 10₆) und jeder Zenerdiode (11; 11₁, 11₂, 11₃, 11₄, 11ₛ, 11₆) innerhalb jeder Begrenzungsstufe (8; 8₁, 8₂, 8₃, 8₄, 8₅, 8₆) für eine erste Betriebsfrequenz kompensiert ist.

5. Begrenzer nach Anspruch 4,
**dadurch gekennzeichnet,**
**dass** über zumindest einen ersten Schalter (41; 41₁, 41₂) jeweils zumindest eine zusätzliche Induktivität (40ₙ) zu der ersten Induktivität (40; 40₁) parallel oder in Serie zugeschalten ist, deren Höhe so gewählt ist, dass die Sperrschichtkapazität jeder Diode (10; 10₁, 10₂, 10₃, 10₄, 10₅, 10₆) und jeder Zenerdiode (11; 11₁, 11₂, 11₃, 11₄, 11ₛ, 11₆) innerhalb jeder Begrenzungsstufe (8; 8₁, 8₂, 8₃, 8₄, 8₅, 8₆) für eine andere Betriebsfrequenz kompensiert ist.

6. Begrenzer nach einem der vorherigen Ansprüche,
**dadurch gekennzeichnet,**
**dass** es sich bei jeder der Dioden (10; 10₁, 10₂, 10₃, 10₄, 10₅, 10₆) um eine Pin-Diode handelt.

7. Begrenzer nach einem der vorherigen Ansprüche,
**dadurch gekennzeichnet,**
**dass** innerhalb der Begrenzungsstufe (8; 8₁, 8₂, 8₃, 8₄, 8₅, 8₆) und/oder an die Begrenzungsstufe (8; 8₁, 8₂, 8₃, 8₄, 8₅, 8₆) keine zusätzlichen Elemente in Reihe zu der Diode (10; 10₁, 10₂, 10₃, 10₄, 10s, 10₆) und der Zenerdiode (11; 11₁, 11₂, 11₃, 11₄, 11ₛ, 11₆) geschalten sind und/oder dass innerhalb der Begrenzungsstufe (8; 8₁, 8₂, 8₃, 8₄, 8₅, 8₆) mit Ausnahme von weiteren Begrenzungsstufen (8; 8₁, 8₂, 8₃, 8₄, 8₅, 8₆) keine zusätzlichen Elemente parallel zu der Diode (10; 10₁, 10₂, 10₃, 10₄, 10₅, 10₆) und der Zenerdiode (11; 11₁, 11₂, 11₃, 11₄, 11ₛ, 11₆) geschalten sind.

8. Begrenzer nach Anspruch 7,
**dadurch gekennzeichnet,**
**dass** es sich bei den Elementen um aktive Bauelemente, insbesondere Transistoren, und/oder passive Bauelemente, insbesondere Kondensatoren, handelt.

9. Funkgerät (1) zur mobilen Kommunikation aufweisend eine Antenne (3) und einen Begrenzer (2) nach einem der vorherigen Ansprüche,
**dadurch gekennzeichnet,**
**dass** die Antenne (3) mit dem Eingang (5) des Begrenzers (2) verbunden ist oder
**dass** die Antenne (3) über einen Bandpass (4) mit dem Eingang (5) des Begrenzers (2) verbunden ist.

## Claims

1. Limiter (2) for high-frequency signals, comprising an input (5), wherein a high-frequency signal is fed to the limiter (2) at its input (5), wherein the limiter (2) has at least one limiting stage (8; 8₁, 8₂, 8₃, 8₄, 8₅, 8₆), which is electrically connected to the input (5),
wherein the limiting stage (8; 8₁, 8₂, 8₃, 8₄, 8₅, 8₆) contains a series circuit with an unbiased diode (10; 10₁, 10₂, 10₃, 10₄, 10₅, 10₆) and a Zener diode (11; 11₁, 11₂, 11₃, 11₄, 11₅, 11₆) that does not serve to bias the diode, so that the high-frequency signal is electrically connected to a reference ground via the unbiased diode (10; 10₁, 10₂, 10₃, 10₄, 10₅, 10₆) and the Zener diode (11; 11₁, 11₂, 11₃, 11₄, 11₅, 11₆), and
wherein the high-frequency signal is present at an anode of a first diode (10; 10₁, 10₃, 10₅) in at least one positive limiting stage (8; 8₁, 8₃, 8₅), and a cathode of the first diode (10; 10₁, 10₃, 10₅) is electrically connected to a cathode of a first Zener diode (11; 11₁, 11₃, 11ₛ), and an anode of the first Zener diode (11; 11₁, 11₃, 11₅) is electrically connected to the reference ground, as a result of which the at least one positive limiting stage (8; 8₁, 8₃, 8₅) limits a positive half-wave of the high-frequency signal,
and/or
the high-frequency signal is present at a cathode of a second diode (10₂, 10₄, 10₆) in at least one negative limiting stage (8₂, 8₄, 8₆), and an anode of the second diode (10₂, 10₄, 10₆) is electrically connected to an anode of a second Zener diode (11₂, 11₄, 11₆), and a cathode of the second Zener diode (11₂, 11₄, 11₆) is electrically connected to the reference ground, as a result of which the at least one negative limiting stage (8₂, 8₄, 8₆) limits a negative half-wave of the high-frequency signal,
wherein the limiter does not bias the diodes, and
wherein the limiter (2) has an output (6), the output being electrically connected to the input (5) via a line section (9),
**characterized**
**in that** the limiter (2) has at least two of the positive limiting stages (8; 8₁, 8₃, 8₅) that limit a positive half-wave of the high-frequency signal, and/or
**in that** the limiter (2) has at least two of the negative limiting stages (8₂, 8₄, 8₆) that limit a negative half-wave of the high-frequency signal, the at least two positive limiting stages (8; 8₁, 8₃, 8₅) that limit the positive half-wave being connected at different connection points (12; 12₁, 12₂, 12₃) of the line section (9), and/or the at least two negative limiting stages (8₂, 8₄, 8₆) that limit the negative half-wave being connected at different connection points (12; 12₁, 12₂, 12₃) of the line section (9); and
**in that** the at least one limiting stage (8; 8₁, 8₂, 8₃, 8₄, 8₅, 8₆) is separably connected to the line section (9) via at least one switch (41₃, 41₄) .

2. Limiter according to claim 1,
**characterized**
**in that** the at least two positive limiting stages (8; 8₁, 8₃, 8₅) that limit a positive half-wave of the high-frequency signal are of identical construction, and/or
**in that** the at least two negative limiting stages (8₂, 8₄, 8₆) that limit a negative half-wave of the high-frequency signal are of identical construction.

3. Limiter according to any one of claims 1 or 2, **characterized**
**in that** a positive limiting stage (8; 8₁, 8₃, 8₅) that limits a positive half-wave of the high-frequency signal is connected at each connection point (12; 12₁, 12₂, 12₃) , and
**in that** a negative limiting stage (8₂, 8₄, 8₆) that limits a negative half-wave of the high-frequency signal is also connected at each connection point (12; 12₁, 12₂, 12₃).

4. Limiter according to any one of claims 1 to 3, **characterized**
**in that** a first inductance (40; 40₁) is connected into the line section (9), the level of the first inductance being selected in such a way that the depletion-layer capacitance of each diode (10; 10₁, 10₂, 10₃, 10₄, 10₅, 10₆) and of each Zener diode (11; 11₁, 11₂, 11₃, 11₄, 11₅, 11₆) within each limiting stage (8; 8₁, 8₂, 8₃, 8₄, 8₅, 8₆) is compensated for a first operating frequency.

5. Limiter according to claim 4,
**characterized**
**in that** in each case at least one additional inductance (40ₙ) is connected in parallel or in series with the first inductance (40; 40₁) via at least one first switch (41; 41₁, 41₂), the level of said additional inductance being selected in such a way that the depletion-layer capacitance of each diode (10; 10₁, 10₂, 10₃, 10₄, 10₅, 10₆) and of each Zener diode (11; 11₁, 11₂, 11₃, 11₄, 11₅, 11₆) within each limiting stage (8; 8₁, 8₂, 8₃, 8₄, 8₅, 8₆) is compensated for another operating frequency.

6. Limiter according to any one of the preceding claims, **characterized**
**in that** each of the diodes (10; 10₁, 10₂, 10₃, 10₄, 10₅, 10₆) is a pin diode.

7. Limiter according to any one of the preceding claims, **characterized**
**in that**, within the limiting stage (8; 8₁, 8₂, 8₃, 8₄, 8₅, 8₆) and/or on the limiting stage (8; 8₁, 8₂, 8₃, 8₄, 8₅, 8₆), no additional elements are connected in series with the diode (10; 10₁, 10₂, 10₃, 10₄, 10₅, 10₆) and the Zener diode (11; 11₁, 11₂, 11₃, 11₄, 11₅, 11₆), and/or
**in that**, within the limiting stage (8; 8₁, 8₂, 8₃, 8₄, 8₅, 8₆), no additional elements are connected in parallel with the diode (10; 10₁, 10₂, 10₃, 10₄, 10₅, 10₆) and the Zener diode (11; 11₁, 11₂, 11₃, 11₄, 11₅, 11₆) apart from further limiting stages (8; 8₁, 8₂, 8₃, 8₄, 8₅, 8₆).

8. Limiter according to claim 7,
**characterized**
**in that** the elements are active components, in particular transistors, and/or passive components, in particular capacitors.

9. Radio device (1) for mobile communications, comprising an antenna (3) and a limiter (2) according to any one of the preceding claims,
**characterized**
**in that** the antenna (3) is connected to the input (5) of the limiter (2), or
**in that** the antenna (3) is connected to the input (5) of the limiter (2) via a band-pass filter (4).

## Revendications

1. Limiteur (2) pour des signaux haute fréquence qui présente une entrée (5), dans lequel un signal haute fréquence est amené au limiteur (2) au niveau de son entrée (5), dans lequel le limiteur (2) présente au moins un étage limiteur (8 ; 8₁; 8₂; 8₃; 8₄; 8₅; 8₆) qui est électriquement relié à l'entrée (5),
dans lequel l'étage limiteur (8 ; 8₁ ; 8₂ ; 8₃ ; 8₄ ; 8₅ ; 8₆) contient un montage en série avec une diode (10 ; 10₁ ; 10₂ ; 10₃ ; 10₄ ; 10₅ ; 10₆) non polarisée et une diode Zener (11 ; 11₁ ; 11₂ ; 11₃ ; 11₄ ; 11₅ ; 11₆), laquelle ne sert pas à polariser la diode, de sorte que le signal haute fréquence soit électriquement relié à une masse de référence via la une diode (10; 10₁; 10₂; 10₃; 10₄; 10₅; 10₆) non polarisée et la diode Zener (11 ; 11₁ ; 11₂ ; 11₃ ; 11₄ ; 11₅ ; 11₆), et
dans lequel le signal haute fréquence repose contre une anode d'une première diode (10 ; 10₁ ; 10₃ ; 10₅) dans au moins un étage limiteur positif (8 ; 8₁ ; 8₃ ; 8₅) et une cathode de la première diode (10; 10₁ ; 10₃; 10₅) est électriquement reliée à une cathode d'une première diode Zener (11 ; 11₁ ; 11₃ ; 11₅) et une anode de la première diode Zener (11 ; 11₁ ; 11₃ ; 11₅) est électriquement reliée à la masse de référence, moyennant quoi le au moins un étage limiteur positif (8 ; 8₁ ; 8₃ ; 8₅) délimite une demi-onde positive du signal haute fréquence,
et/ou
le signal haute fréquence repose contre une cathode d'une seconde diode (10₂ ; 10₄ ; 10₆) dans au moins un étage limiteur négatif (8₂ ; 8₄ ; 8₆) et une anode de la seconde diode (10₂ ; 10₄ ; 10₆) est électriquement reliée à une anode d'une seconde diode Zener (11₂ ; 11₄ ; 11₆) et une cathode de la seconde diode Zener (11₂ ; 11₄ ; 11₆) est électriquement reliée à la masse de référence, moyennant quoi le au moins un étage limiteur négatif (8₂ ; 8₄ ; 8₆) délimite une demi-onde positive du signal haute fréquence,
dans lequel le limiteur ne polarise pas les diodes, et dans lequel le limiteur (2) présente une sortie (6), dans lequel la sortie est électriquement reliée à l'entrée (5) via un tronçon de ligne (9),
**caractérisé en ce que**
le limiteur (2) présente au moins deux des étages limiteurs positifs (8 ; 8₁ ; 8₃ ; 8₅) qui délimitent une demi-onde positive du signal haute fréquence, et/ou
**en ce que** le limiteur (2) présente au moins deux des étages limiteurs négatifs (8₂ ; 8₄ ; 8₆) qui délimitent une demi-onde négative du signal haute fréquence, dans lequel les au moins deux étages limiteurs positifs (8 ; 8₁ ; 8₃ ; 8₅) qui délimitent la demi-onde positive sont raccordés à des points de jonction (12 ; 12₁ ; 12₂ ; 12₃) différents du tronçon de ligne (9) et/ou les au moins deux étages limiteurs négatifs (8₂ ; 8₄ ; 8₆) qui délimitent la demi-onde négative sont raccordés à des points de jonction (12 ; 12₁ ; 12₂ ; 12₃) différents du tronçon de ligne (9) ; et **en ce que** le au moins un étage limiteur (8 ; 8₁ ; 8₂ ; 8₃ ; 8₄ ; 8₅ ; 8₆) est relié au tronçon de ligne (9) de façon à pouvoir être séparé via au moins un commutateur (41₃, 41₄) .

2. Limiteur selon la revendication 1,
**caractérisé en ce que**
les au moins deux étages limiteurs positifs (8 ; 8₁ ; 8₃ ; 8₅) qui délimitent une demi-onde positive du signal haute fréquence sont assemblés de façon identique et/ou
**en ce que** les au moins deux étages limiteurs négatifs (8₂ ; 8₄ ; 8₆) qui délimitent une demi-onde négative du signal haute fréquence sont assemblés de façon identique.

3. Limiteur selon l'une des revendications 1 ou 2, **caractérisé en ce que**
au niveau de chaque point de jonction (12 ; 12₁ ; 12₂ ; 12₃) est raccordé un étage limiteur positif (8 ; 8₁ ; 8₃ ; 8₅) qui délimite une demi-onde positive du signal haute fréquence, et
**en ce qu'**au niveau de chaque point de jonction (12 ; 12₁ ; 12₂ ; 12₃) est en outre raccordé un étage limiteur négatif (8₂ ; 8₄ ; 8₆) qui délimite une demi-onde négative du signal haute fréquence.

4. Limiteur selon l'une des revendications 1 à 3, **caractérisé en ce que**
dans le tronçon de ligne (9) est montée une première inductance (40 ; 40₁) dont la hauteur est sélectionnée de telle sorte que la capacité de couche d'arrêt de chaque diode (10 ; 10₁ ; 10₂ ; 10₃ ; 10₄ ; 10₅ ; 10₆) et de chaque diode Zener (11 ; 11₁ ; 11₂ ; 11₃ ; 11₄ ; 11₅ ; 11₆) soit compensée à l'intérieur de chaque étage limiteur (8 ; 8₁ ; 8₂ ; 8₃ ; 8₄ ; 8₅ ; 8₆) pour une première fréquence de fonctionnement.

5. Limiteur selon la revendication 4,
**caractérisé en ce que**
via au moins un premier commutateur (41 ; 41₁, 41₂) est respectivement montée en parallèle ou en série au moins une inductance (40ₙ) supplémentaire à la première inductance (40 ; 40₁), dont la hauteur est sélectionnée de telle sorte que la capacité de couche d'arrêt de chaque diode (10 ; 10₁ ; 10₂ ; 10₃ ; 10₄ ; 10₅ ; 10₆) et de chaque diode Zener (11 ; 11₁ ; 11₂ ; 11₃ ; 11₄ ; 11₅ ; 11₆) soit compensée pour une autre fréquence de fonctionnement à l'intérieur de chaque étage limiteur (8 ; 8₁ ; 8₂ ; 8₃ ; 8₄ ; 8₅ ; 8₆) .

6. Limiteur selon l'une des revendications précédentes, **caractérisé en ce que**
chacune des diodes (10 ; 10₁ ; 10₂ ; 10₃ ; 10₄ ; 10₅ ; 10₆) est une diode PIN.

7. Limiteur selon l'une des revendications précédentes, **caractérisé en ce que**
à l'intérieur de l'étage limiteur (8 ; 8₁ ; 8₂ ; 8₃ ; 8₄ ; 8₅ ; 8₆) et/ou au niveau de l'étage limiteur (8 ; 8₁ ; 8₂ ; 8₃ ; 8₄ ; 8₅ ; 8₆) aucun élément supplémentaire n'est monté en série avec la diode (10; 10₁ ; 10₂ ; 10₃; 10₄ ; 10₅ ; 10₆) et la diode Zener (11 ; 11₁ ; 11₂ ; 11₃ ; 11₄ ; 11₅ ; 11₆) et/ou
**en ce qu'**à l'intérieur de l'étage limiteur (8 ; 8₁ ; 8₂ ; 8₃ ; 8₄ ; 8₅ ; 8₆), à l'exception d'autres étages limiteurs (8 ; 8₁ ; 8₂ ; 8₃ ; 8₄ ; 8₅ ; 8₆), aucun élément supplémentaire n'est monté en parallèle avec la diode (10 ; 10₁ ; 10₂ ; 10₃ ; 10₄ ; 10₅ ; 10₆) et la diode Zener (11 ; 11₁ ; 11₂ ; 11₃ ; 11₄ ; 11₅ ; 11₆) .

8. Limiteur selon la revendication 7,
**caractérisé en ce que**
les éléments sont des composants actifs, en particulier des transistors, et/ou des composants passifs, en particulier des condensateurs.

9. Poste émetteur-récepteur (1) pour une communication mobile qui présente une antenne (3) et un limiteur (2) selon l'une des revendications précédentes,
**caractérisé en ce que**
l'antenne (3) est reliée à l'entrée (5) du limiteur (2) ou en ce que l'antenne (3) est reliée à l'entrée (5) du limiteur (2) via un passe-bande (4).
